# FASCICULE DE BREVET EUROPEEN

(11) **EP 1 688 956 B1**
(45) Date de publication et mention de la délivrance du brevet: **28.01.2009**
(21) Numéro de dépôt: 06101285.2
(22) Date de dépôt: 03.02.2006
(51) Int. Cl.: G11C 11/406

(54) **Mémoire dynamique pour terminal cellulaire**
Dynamische Speicheranordnung für ein mobiles Telefon
Dynamic memory for mobile phone

(30) Priorité: 04.02.2005 FR 0550338
(43) Date de publication de la demande: 09.08.2006
(73) Titulaire: ST MICROELECTRONICS S.A., 92120 Montrouge (FR)
(72) Inventeur: Druilhe, François, 38420 Le Versoud (FR); Cofler, Andrew, 38140 La Murette (FR); Dutoit, Denis, 38120 Fontanil-Cornillon (FR); Harrand, Michel, 38120 Saint Egreve (FR); Eyzat, Gilles, 38640 Claix (FR); Freund, Christian, 38560 Jarrie (FR)
(74) Mandataire: de Beaumont, Michel

(56) Documents cités:
- US-A- 4 313 180
- US-A- 5 703 823

## Description

### Domaine de l'invention

La présente invention concerne de façon générale les mémoires dynamiques (DRAM) qui constituent des mémoires volatiles nécessitant un rafraîchissement des cellules pour maintenir l'information qu'elles contiennent. La présente invention s'applique plus particulièrement aux systèmes mobiles alimentés par une batterie, par exemple, les téléphones portables ou les terminaux cellulaires de type 3G/EGPRS/GSM.

### Exposé de l'art antérieur

Les mémoires dynamiques sont généralement constituées d'un réseau matriciel de cellules mémoires auquel sont associés des circuits d'adressage et d'entrée-sortie ainsi qu'un circuit de rafraîchissement. Le circuit de rafraîchissement sert à adresser périodiquement toutes les cellules de la mémoire afin de préserver l'information qu'elles contiennent.

Dans l'application au téléphone portable, de telles mémoires dynamiques sont généralement utilisées dans des circuits annexes (écran, caméra, système de localisation par satellites assisté par le réseau GSM - A-GPS, ...) au circuit de base de téléphonie (modem).

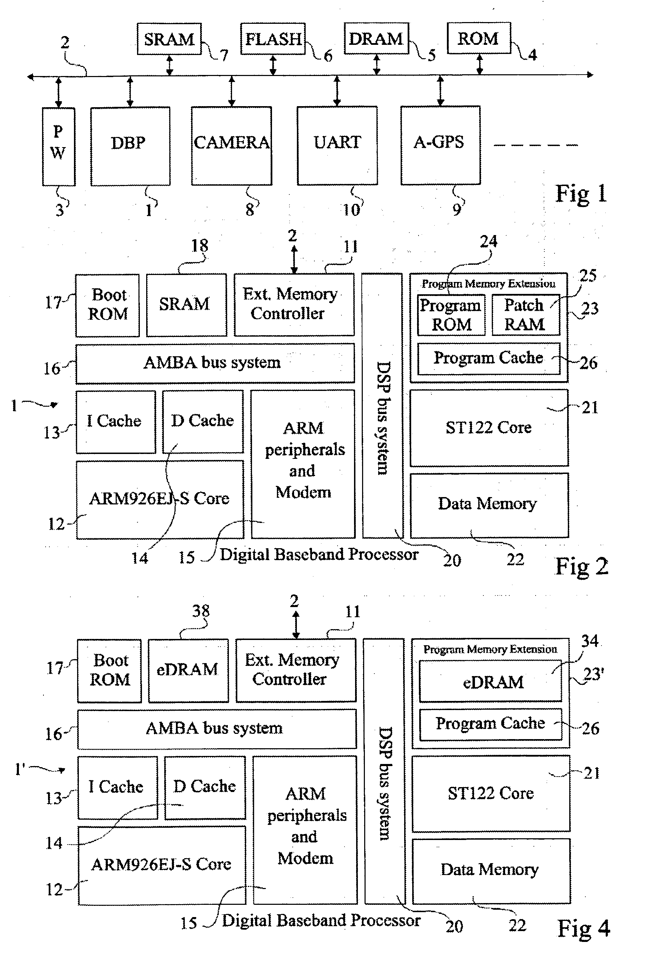

La figure 1 représente, de façon très schématique et sous forme de blocs, un exemple classique d'architecture simplifiée des circuits numériques d'un téléphone mobile de type GSM. Pour simplifier, seuls les circuits numériques ont été représentés alors que le téléphone comporte bien entendu des circuits d'émission-réception radiofréquence pour communiquer avec le réseau GSM et ses stations.

L'élément principal du téléphone est un circuit 1 (DBP ou Digital Baseband Processor) constituant le circuit de téléphonie et comprenant les éléments de modulation-démodulation nécessaires aux communications avec le réseau GSM. A l'intérieur du téléphone, ce circuit 1 est relié par un ou plusieurs bus 2 d'échange de données, d'adresses et de signaux de commande et d'alimentation aux autres éléments du téléphone mobile. Parmi les circuits reliés aux bus 2, on trouve un circuit 3 (PW) de gestion d'énergie, des circuits 8 (CAMERA) d'application, par exemple de caméra ou d'appareil photo, des circuits 9 de localisation satellite (A-GPS), une unité 10 (par exemple une unité arithmétique et logique - UART) de communication asynchrone avec l'extérieur (par exemple avec un PC), et différentes mémoires, par exemple, une mémoire non volatile (ROM), une mémoire 5 dynamique (DRAM), une mémoire 6 (FLASH) de type flash et une mémoire vive statique 7 (SRAM). D'autres constituants sont présents dans le téléphone notamment pour gérer les éléments de type clavier, etc.

La présente invention s'applique plus particulièrement au circuit 1 constituant le circuit de téléphonie qui, à la différence des autres circuits applicatifs contenus dans le téléphone, doit continuer à fonctionner en mode veille du téléphone mobile, notamment pour communiquer périodiquement avec le réseau GSM et être réveillé à réception d'un appel entrant.

La figure 2 représente, de façon très schématique et sous forme de blocs, un exemple d'architecture classique de circuit 1 de téléphonie d'un terminal GSM. Tous les éléments illustrés en figure 2 sont intégrés sur une même puce.

Le circuit 1 comporte essentiellement :
un contrôleur 11 de mémoire externe (Ext. Memory Controller) pour communiquer avec le bus 2 ;
un microprocesseur 12 (ARM926EJ-S Core) associé à deux éléments 13 (I Cache) et 14 (D Cache) de mémoire cache ;
un circuit 15 (ARM peripherals and Modem) contenant des périphériques du microprocesseur ainsi qu'un modem pour communiquer avec des circuits analogiques (non représentés) d'émission-réception radiofréquence ;
une mémoire vive statique 18 (SRAM) ;
une mémoire morte de démarrage (Boot ROM) ; et
un système de bus interne 16 (AMBA bus system) dédié au microprocesseur 12 et auquel sont reliés notamment les circuits 11, 12, 13, 14, 15, 17 et 18.

Le plus souvent, un circuit de téléphonie comporte également :
un processeur 21 (ST122 Core) de traitement du signal (DSP) associé à une mémoire de données 22 de type mémoire vive statique (SRAM) ;
un circuit 23 d'extension de mémoire programme (Program Memory Extension) comportant un circuit 24 de mémoire morte (Program ROM) pour contenir des programmes dédiés au processeur 21, un circuit 25 (Patch RAM) de mémoire statique pour contenir des mises à jour de ces programmes pendant la vie du circuit et un circuit 26 de mémoire cache (Program Cache) dédié au processeur 21 ; et
un système de gestion de bus 20 (DSP bus system) auquel sont reliés les circuits dédiés au processeur 21 et qui est lui-même relié au bus principal 16.

Pour simplifier, les différentes liaisons entre les éléments à l'intérieur du circuit 1 n'ont pas été représentées et seule la liaison aux bus 2 depuis le contrôleur 11 a été illustrée.

Le fonctionnement d'un tel circuit de téléphonie est connu et n'a pas besoin d'être détaillé plus avant pour l'exposé de l'invention.

Les circuits de téléphonie classiques souffrent de plusieurs inconvénients liés aux circuits mémoire utilisés. En particulier, côté processeur de traitement du signal 21, l'utilisation d'une mémoire morte 24 pour contenir les programmes nuit à la flexibilité du processeur de traitement du signal et aux mises à jour nécessaires de son contenu.

On a déjà pensé remplacer cette mémoire par de la mémoire flash, mais les mémoires flash ont l'inconvénient de ne pas être programmable à la volée, c'est-à-dire par des communications avec le réseau GSM pour modifier des applications dans la vie du téléphone.

Quand aux mémoires statiques (SRAM), elles posent des problèmes de taille et de consommation pendant leur fonctionnement. C'est notamment pourquoi on cherche classiquement à minimiser la taille des circuits 18 et 25 qui sont des mémoires statiques.

Le recours aux mémoires statiques ou mortes est lié à leur caractère non volatile n'engendrant pas de consommation pour maintenir l'information pendant les périodes de veille du téléphone.

Côté microprocesseur 12, la présence d'un circuit 18 de mémoire statique nuit à la taille et à la consommation du système.

En outre, les capacités des mémoires requises par les téléphones mobiles et plus généralement les terminaux GSM deviennent de plus en plus importantes. Cet accroissement de capacité classiquement effectué au moyen de mémoires statiques n'est pas souhaitable.

Ces problèmes sont essentiellement présents pour le circuit de téléphonie 1. En effet, les autres circuits du terminal GSM sont moins sensibles dans la mesure où ils ne sont pas actifs pendant les périodes de veille du téléphone.

L'utilisation de mémoires dynamiques constituerait une solution. Toutefois, ces mémoires sont volatiles et nécessitent un rafraîchissement permanent pour préserver les informations qu'elles contiennent. Elles ont donc été jusqu'à présent écartées en raison de la trop forte consommation engendrée par un tel rafraîchissement.

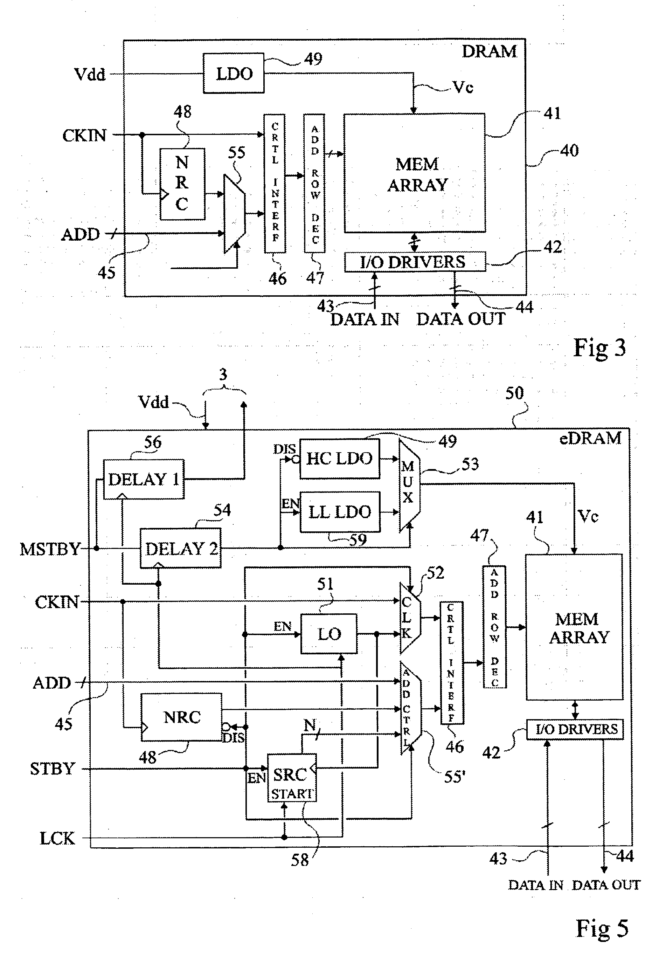

La figure 3 représente, de façon schématique et sous forme de blocs, un exemple d'architecture classique d'un circuit 40 de mémoire dynamique (DRAM). Un tel circuit comporte essentiellement un réseau matriciel 41 (MEM ARRAY) de cellules mémoires connecté par des circuits 42 d'entrée-sortie (I/O DRIVERS) à un bus 43 de données entrantes (DATA IN) et à un bus 44 de données sortantes (DATA OUT). Le circuit 40 comporte une entrée de bus 45 d'adresses (ADD) relié, par un multiplexeur de sélection 55 à une interface de commande 46 (CTRL INTERF). Une deuxième entrée du multiplexeur reçoit des adresses générées automatiquement par un contrôleur de rafraîchissement 48 (NRC) générant périodiquement toutes les adresses du réseau 41 afin de préserver les informations qu'elles contiennent. Le circuit 48 reçoit un signal d'horloge CKIN provenant de l'extérieur du circuit 40 qui est également envoyé directement à l'interface de commande 46. Le sélecteur 55 est commandé par un signal provenant d'un circuit de contrôle non représenté de la mémoire. L'interface 46 fournit des adresses à un décodeur d'adresses 47 (ADD ROW DEC) de sélection des cellules mémoires adressées dans le réseau 41 et à une précharge des lignes de bits. Enfin, le circuit 40 intègre un régulateur linéaire 49 recevant une tension d'alimentation Vdd depuis l'extérieur et fournissant une tension d'alimentation Vc régulée, entre autres, à une des électrodes (en pratique, l'électrode commune) de tous les éléments capacitifs du réseau 41. Pour simplifier, la figure 4 ne représente que les éléments et connexions utiles au rafraîchissement. La mémoire 40 comporte bien entendu d'autres circuits utilisés pour le transfert des données et le mode utilisateur ainsi qu'un circuit général de commande. En outre, le circuit 40 peut échanger d'autres signaux avec l'extérieur, par exemple, par un bus de commande.

L'architecture de la figure 4 correspond, par exemple, à celle de la mémoire 5 (figure 1).

L'intégration d'une mémoire telle qu'illustrée par la figure 3 dans un circuit de téléphonie est incompatible avec les besoins de faible consommation de ce circuit en période de veille.

En effet, lorsque le téléphone mobile est en veille, le processeur téléphonique ne fonctionne qu'avec des fonctions limitées et sous une tension d'alimentation réduite. Ces fonctions limitées sont notamment l'interrogation périodique des stations de base du réseau GMS pour détecter un éventuel appel entrant ainsi qu'une fonction de réveil du circuit par l'utilisateur lui-même. En veille, les circuits internes de génération d'une horloge haute fréquence (plusieurs dizaines de MHz) pour le fonctionnement des processeurs et le rafraîchissement des mémoires DRAM (signal CKIN) sont désactivés.

Or, le rafraîchissement des cellules mémoire requiert d'une part une fréquence d'horloge et d'autre part une tension d'alimentation suffisante. Plus la capacité mémoire est importante, plus la fréquence d'horloge doit être élevée pour permettre un rafraîchissement compatible avec la capacité de rétention des cellules. Typiquement, le temps de rétention d'une mémoire dynamique est de quelques dizaines de millisecondes.

Une autre difficulté est que la tension d'alimentation fournie au circuit de téléphonie est différente entre le mode de veille et le mode actif. Typiquement, dans les circuits de téléphonie de type GSM, cette tension passe de l'ordre de 1,2 volts en activité à environ 0,95 volt en veille.

Ces contraintes font que les mémoires dynamiques classiques sont inadaptées.

Le document US-A-4 313 180 décrit un système de rafraîchissement pour une mémoire dynamique générant deux signaux de rafraîchissement.

### Résumé de l'invention

La présente invention vise à pallier tout ou partie des inconvénients des mémoires embarquées dans les circuits de téléphonie classiques.

L'invention est définie dans les revendications 1 et 7.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 qui a été décrite précédemment représente sous forme de blocs, de façon partielle et très schématique, un exemple d'architecture de téléphone mobile du type auquel s'applique plus particulièrement la présente invention ;
la figure 2 qui a été décrite précédemment représente, de façon très schématique et sous forme de blocs, un exemple d'architecture classique de circuit de téléphonie du type auquel s'applique la présente invention ;
la figure 3 qui a été décrite précédemment représente sous forme de blocs, de façon partielle et schématique, un exemple d'architecture classique de mémoire dynamique ;
la figure 4 représente, de façon très schématique et sous forme de blocs, un mode de réalisation de circuit de téléphonie selon la présente invention ;
la figure 5 représente sous forme de blocs, de façon partielle et schématique, un mode de réalisation d'une mémoire dynamique selon la présente invention ; et
la figure 6 représente des chronogrammes illustrant le fonctionnement de la mémoire dynamique de la figure 5.

Les mêmes éléments ont été désignés par les mêmes références aux différentes figures qui ont été tracées sans respect d'échelle. Par souci de clarté, seuls les éléments qui sont nécessaires à la compréhension de l'invention ont été représentés aux figures et seront décrits par la suite. En particulier, les détails constitutifs d'un terminal GSM n'ont pas été exposés, l'invention étant compatible avec tout terminal GSM classique. De plus, la structure interne d'un plan mémoire d'une mémoire dynamique n'a pas été détaillée, la mise en oeuvre de l'invention étant là encore compatible avec les structures classiques.

### Description détaillée

La présente invention sera décrite par la suite en relation avec une application à l'intégration, dans un circuit de téléphonie, d'une mémoire dynamique. Elle s'applique toutefois plus généralement à la réalisation d'une mémoire dynamique dont la consommation s'adapte à différentes phases de fonctionnement et à son utilisation dans toute application requérant ces différents modes de fonctionnement.

La figure 3 représente, de façon très schématique et sous forme de blocs, un mode de réalisation d'un circuit 1' (Digital Baseband Processor) de téléphonie constituant un processeur numérique en bande de base.

Comme précédemment, ce circuit intègre essentiellement un microprocesseur 12 (ARM926EJ-S Core) associé à deux mémoires 13 (I Cache) et 14 (D Cache), à une mémoire morte 17 (Boot ROM) contenant les programmes de démarrage et à un circuit 15 (ARM peripherals and Modem) de périphériques et modem. Le microprocesseur 12 communique par un bus interne 16 (AMBA bus system) avec ces différents éléments ainsi qu'avec un contrôleur de mémoire externe 11 (Ext. Memory Controller) lui-même relié au bus principal 2 (figure 1) du terminal GSM. Le bus 16 communique par ailleurs avec un deuxième bus 20 (DSP bus system) dédié dans cet exemple à un processeur de traitement du signal 21 (ST122 Core) optionnel. Ce processeur 21 est, comme précédemment, associé à une mémoire de données 22 statique de type SRAM ainsi qu'à un circuit 23' (Program Memory Extension) d'extension de mémoire programme comprenant, entre autres, une mémoire cache 26 (Program Cache).

Selon ce mode de réalisation de l'invention, le circuit 1' comporte également une mémoire dynamique intégrée avec les autres éléments (embarquée). Dans l'exemple représenté, un premier circuit 38 (eDRAM) est associé au microprocesseur principal 12 en étant relié au système de bus 16, tandis qu'un deuxième circuit 34 est associé au processeur de traitement du signal 21 en étant compris dans le circuit 23' d'extension de mémoire programme. Le circuit 38 remplace la mémoire statique 18 et le circuit 34 remplace au moins le circuit 24 et préférentiellement les circuits 24 et 25 de l'architecture classique de la figure 2.

L'invention prévoit d'embarquer (d'intégrer) avec un circuit de téléphonie, des mémoires dynamiques et de rendre ces mémoires non volatiles par un rafraîchissement approprié.

La figure 5 représente un mode de réalisation d'un circuit 50 (eDRAM) de mémoire dynamique selon l'invention.

Comme précédemment, le circuit 50 comporte un réseau matriciel 41 de cellules mémoires (MEM ARRAY) relié par des circuits 42 d'entrée-sortie (I/O DRIVERS) à un bus 43 d'entrée de données (DATA IN) et à un bus 44 de sortie de données (DATA OUT). Les cellules du réseau 41 sont sélectionnées par un décodeur d'adresses 47 (ADD ROW DEC) commandé par un circuit 46 (CTRL INTERF) d'interface de commande. Le circuit 50 comporte également un premier contrôleur de rafraîchissement 48 (NRC) commandé par une horloge CKIN provenant de l'extérieur, une entrée de bus d'adresses 45 (ADD) de l'extérieur, et un premier régulateur linéaire 49 (HC LDO) recevant une tension d'alimentation Vdd de l'extérieur.

Selon ce mode de réalisation de l'invention, un deuxième circuit de rafraîchissement 58 (SRC) destiné à fonctionner pendant les périodes de veille du système fournit des adresses à un multiplexeur 55' (ADD CTRL) constituant un sélecteur d'adresses et dont deux autres entrées reçoivent respectivement les adresses fournies par le premier circuit de rafraîchissement 48 et par le bus 45 d'adresses externe. La sortie du sélecteur 55' est envoyée sur le circuit 46.

Par ailleurs, le circuit 50 comporte un oscillateur local 51 (LO) chargé de fournir une horloge pendant les périodes de veille. La sortie de l'oscillateur local 51 est reliée à une première entrée d'un multiplexeur 52 de sélection entre cette sortie et le signal CKIN provenant de l'extérieur, la sortie du multiplexeur 52 fournissant le signal d'horloge à l'interface de commande 46. L'oscillateur local 51 reçoit, comme fréquence d'horloge, un deuxième signal LCK provenant de l'extérieur, de fréquence inférieure à la fréquence de l'horloge CKIN.

Dans l'application à la téléphonie, le signal LCK est généré par un circuit dédié que comporte le terminal et sa fréquence correspond à la fréquence de synchronisation des événement du réseau GSM (32,768 kHz). L'horloge CKIN provient d'une boucle à verrouillage de phase (PLL) du circuit de téléphonie (1', figure 3) générant des fréquences de plusieurs dizaines de MHz à destination des circuits numériques.

Dans le mode de réalisation préféré de la figure 5, un deuxième régulateur de tension 59 (LL LDO) est destiné à alimenter le réseau mémoire 41 pendant les périodes de veille avec une tension inférieure à la tension régulée par le premier régulateur 49 pour minimiser sa consommation. Les sorties respectives des régulateurs 49 et 59 sont reliées aux entrées d'un multiplexeur 53 dont la sortie fournit la tension Vc au moins à l'électrode commune des cellules du plan mémoire 41. Les deux régulateurs 49 et 59 reçoivent la tension externe Vdd.

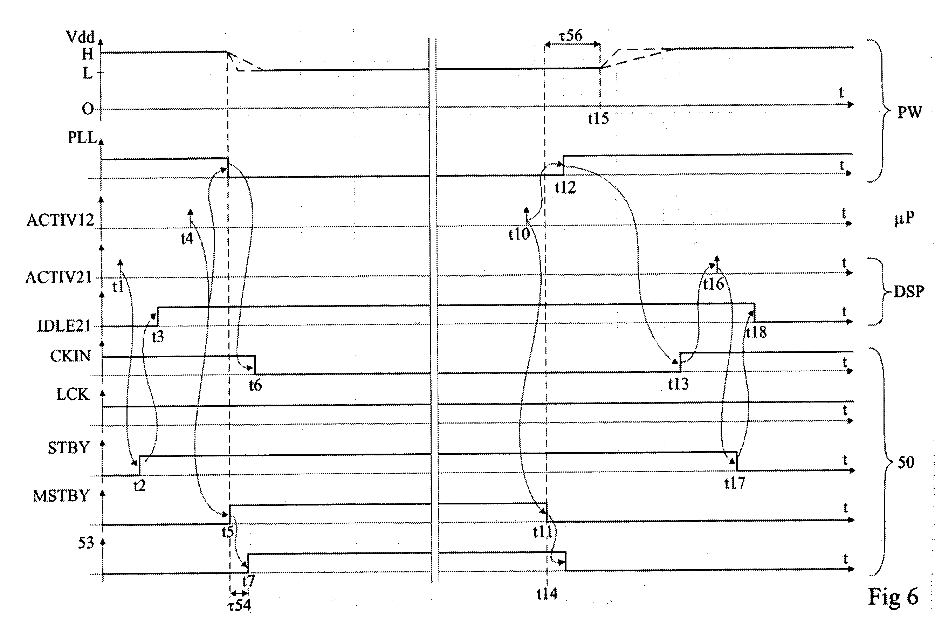

Ces régulateurs sont commandés par un signal MSTBY provenant d'un déclenchement de mise en veille générale du circuit de téléphonie (provenant du microprocesseur 12, figure 3). Deux éléments retardateurs 54 (DELAY2) et 56 (DELAY1) dont le rôle sera exposé en relation avec la figure 6 retardent respectivement la sélection du régulateur 59 et la réactivation du circuit d'alimentation général (bloc 3, figure 1).

Le deuxième contrôleur de rafraîchissement 58 est déclenché par la mise en veille du processeur de traitement du signal 21 (signal STBY). En variante et notamment en l'absence de processeur de traitement du signal dans le circuit de téléphonie, le signal STBY proviendra de la mise en veille du microprocesseur 12. Dans ce cas, les signaux STBY et MSTBY devront être temporellement décalés comme cela ressortira de la description de la figure 6. Le décalage temporel servira à vérifier que la mémoire est bien entrée en mode de rafraîchissement basse consommation avant de commuter le signal MSTBY.

Le signal STBY à l'état actif (veille) active l'oscillateur local 51 et le deuxième contrôleur de rafraîchissement 58 tandis qu'il désactive le contrôleur de rafraîchissement normal 48. Par ailleurs, ce signal STBY à l'état actif sélectionne la sortie de l'oscillateur 51 dans le multiplexeur 52 d'horloge et la troisième entrée (provenant du contrôleur 58) du contrôleur d'adresse 55'.

La figure 6 représente des exemples d'allure de différents signaux du circuit de la figure 5 lors d'une mise en veille du circuit de téléphonie (partie gauche de la figure), puis lors d'une réactivation (partie droite de la figure). Ces chronogrammes représentent respectivement l'allure de la tension Vdd d'alimentation fournie par le circuit du terminal GSM (bloc 3, figure 1), l'état actif ou non d'un circuit PLL (boucle à verrouillage de phase d'horloge) du processeur 12, l'indication (ACTIV12) d'instants de fin de tâche ou de réveil du processeur 12, l'indication (ACTIV21) d'instants de fin de tâche ou de réveil du processeur de traitement du signal 21, un signal IDLE21 indicateur du passage en état de basse consommation du processeur 21, l'état présent ou absent du signal d'horloge CKIN, l'état (toujours présent) du signal LCK provenant du circuit d'horloge du terminal générant la fréquence fixe de 32,768 kHz, l'état du signal STBY de mise en veille du processeur de traitement du signal 21, l'état du signal MSTBY de mise en veille généré par le microprocesseur 12, et l'état du signal de sélection du multiplexeur d'alimentation 53.

En fonctionnement normal, la tension d'alimentation est à un niveau relativement élevée H, la PLL est active, le signal IDLE21 est inactif, l'horloge externe CKIN est présente, les signaux STBY et MSTBY sont à l'état bas et le signal 53 est à l'état bas indiquant une sélection du premier régulateur 49. La mémoire dynamique fonctionne alors de façon classique par un rafraîchissement au moyen du contrôleur 48 commandé par l'horloge CKIN.

On suppose une fin de tâche du processeur de traitement du signal 21 à un instant t1. Cette fin de tâche est symbolisée par un front sur le signal ACTIV21. Suite à cette fin de tâche, le signal STBY commute à l'état haut (instant t2), ce qui provoque un changement d'état du signal IDLE21 indicateur d'un état de veille du processeur de traitement numérique (instant t3). A cet instant t3, le contrôleur de rafraîchissement 48 est désactivé tandis que le processeur de rafraîchissement 58 et l'oscillateur 51 sont activés et que les multiplexeurs 52 et 55' sélectionnent respectivement un signal d'horloge fourni par l'oscillateur local 51 et la sortie du contrôleur 58 pour les adresses de rafraîchissement générées. La tension d'alimentation Vc reste fournie par le régulateur 49.

Dans un premier mode de réalisation plus particulièrement destiné aux mémoires de taille relativement faibles (typiquement jusqu'à 1 Mégabit), le contrôleur 58 génère une instruction de rafraîchissement comme le fait un contrôleur normal. Cette génération est synchronisée par le signal d'horloge LCK qui est fourni sur une entrée (START) de déclenchement du contrôleur 58.

Dans un deuxième mode de réalisation plus particulièrement destiné à des mémoires de plus grande capacité (plusieurs Mégabits), le générateur 58 génère à chaque cycle d'horloge LCK, N adresses à destination du contrôleur 55' de façon à adresser séquentiellement plusieurs cellules du plan mémoire. Le nombre N d'instructions de rafraîchissement dépend du temps de rétention des cellules mémoires. Ce nombre peut être asservi à la température du circuit qui conditionne également ce temps de rétention.

On suppose que le microprocesseur 12 termine sa tâche à un instant t4 légèrement postérieur à l'instant t1. Cette fin de tâche est symbolisée par un front sur le signal ACTIV12 et provoque le changement d'état du signal MSTBY à un instant t5 légèrement postérieur, ainsi que l'arrêt de la PLL. L'arrêt de cette PLL provoque la disparition du signal CKIN (instant t6) et le circuit 50 ne reçoit plus que le signal LCK à fréquence relativement basse. Le microprocesseur 12 vérifie que le signal IDLE21 est actif, indiquant que l'élément 40 fonctionne à la fréquence de rafraîchissent basse, avant de générer le signal MSTBY.

A partir de l'instant t5, l'ensemble du circuit est synchronisé par l'horloge LCK.

Selon le mode de réalisation préféré de l'invention, le passage à l'état haut du signal MSTBY déclenche l'élément retardateur 54 qui fournit le changement d'état au multiplexeur 53 après un retard τ54 (instant t7). Ainsi, à l'instant t7 d'expiration du retard τ54, le régulateur 49 est désactivé tandis que le régulateur 59 est activé. Le recours à un deuxième régulateur dédié à la veille permet de réduire encore la consommation du système.

Le régulateur 49 est destiné à fournir un courant relativement important pour le fonctionnement du circuit à haute fréquence en mode normal. Quand la fréquence est réduite à la fréquence de rafraîchissement de mode veille (32 kHz), la quantité d'énergie requise est moindre. Par conséquent, alors que le régulateur 49 doit être rapide pour s'adapter aux variations d'appel de courant du plan mémoire en fonction des états des cellules adressées à la fréquence CKIN et fournir un courant important en raison du volume de cellules adressées par unité de temps, le régulateur 59 peut être relativement lent (par rapport au régulateur 49) en raison de la faible fréquence de rafraîchissement (rapport d'environ 1000 par rapport à la fréquence CKIN) qui conduit à de moindres variations de courant. Cela permet d'utiliser un régulateur à forte impédance de sortie pour minimiser les fuites.

A l'instant t5, la coupure de la PLL s'accompagne d'une baisse de la tension d'alimentation fournie par le circuit externe (3, figure 1). Cette baisse s'effectue jusqu'à un niveau L (par exemple, de l'ordre de 0,95 volt). Quand la tension est au niveau bas, il est préférable d'utiliser le régulateur 59 à faibles fuites. L'utilisation d'un retard fixe τ54 pourra être remplacé par une mesure de la tension d'alimentation afin de déclencher le régulateur 59 dédié à la veille. On notera que l'instant où la tension Vdd devient basse ne peut pas être connu de manière certaine car il dépend des charges accumulées et d'éléments extérieurs au circuit, ce qui a été illustré par des pointillés pour la transition entre les niveaux H et L dans le premier chronogramme.

Le circuit de téléphonie est alors en veille. La mémoire dynamique est rafraîchie avec une consommation minimale compatible avec les objectifs actuels de tenue des batteries de téléphone mobile.

Ce fonctionnement est compatible avec le reste du fonctionnement du circuit de téléphonie dans lequel, pendant la veille, seuls des circuits logiques dédiés restent activés en étant synchronisés sur l'horloge LCK à la fréquence utilisée pour synchroniser les événements du réseau GSM.

Le signal LCK et l'alimentation relativement basse (par exemple, 0,95 volt) sont présents dès que le terminal (le téléphone mobile) est sous tension. Le contenu des mémoires dynamiques propres à l'invention est préservé tant que le terminal est alimenté.

On suppose un réveil de l'activité par ces circuits logiques à un instant t10, symbolisé par un front sur le signal ACTIV12 du microprocesseur. Cette activation provoque la réactivation (instant t12) de la PLL et la réactivation du circuit de fourniture d'énergie vers le niveau haut. Suite à son démarrage, la PLL met un certain temps pour fournir le signal CKIN (instant t13). Le réveil du microprocesseur 12 provoque également le changement d'état du signal MSTBY (instant t11) qui entraîne le basculement des régulateurs de tension (instant t14, signal 53). Dans ce sens, l'élément retardateur 54 n'est pas actif. Toutefois, cet élément étant synchronisé par le signal LCK, l'instant t14 est synchrone avec l'horloge LCK.

Le changement d'état du signal MSTBY déclenche l'élément retardateur 56 qui, après un retard τ56, fournit un signal de réactivation au circuit 3 de fourniture d'énergie. Le délai τ56 est choisi pour être supérieur au temps nécessaire au basculement des régulateurs internes au circuit 50.

A l'issue du retard τ56 (instant t15), le circuit d'alimentation commence à augmenter la tension Vdd. Comme pour sa diminution, la durée de transition est inconnue (illustrée par un pointillé au premier chronogramme).

Tant que le signal STBY reste à l'état haut, le rafraîchissement de la mémoire dynamique reste assuré sur la base de l'horloge LCK comme dans le mode de veille.

Le processeur de traitement numérique 21 ne peut démarrer qu'une fois le signal d'horloge CKIN présent. A l'instant t13 où l'horloge CKIN apparaît, le processeur 21 est réactivé (front à l'instant t16 sur le signal ACTIV21). Cette activation provoque le changement d'état du signal STBY (instant t17) qui, à son tour provoque le changement d'état du signal IDLE21 (instant t18) .

A partir de l'instant t17, le contrôleur 58 est désactivé de même que l'oscillateur local 51. Le contrôleur de rafraîchissement 48 est réactivé et les multiplexeurs 52 et 55' sélectionnent respectivement l'entrée CKIN et une des entrées parmi l'entrée d'adresse externe et la sortie du contrôleur 48. La sélection entre les deux entrées restant disponibles sur le contrôleur 55' est alors classique.

De préférence, les éléments retardateurs 54 et 56 sont programmables pour qu'au passage dans le mode de veille, l'élément 56 soit inactif tandis que l'élément 54 fournit un retard, par exemple, de deux périodes du signal LCK. En passage en mode normal, c'est l'inverse qui se produit, l'élément 56 fournissant un retard, par exemple, de deux périodes tandis que l'élément 54 est désactivé. L'adaptation des retards τ54 et τ56 dépend des temps de commutation et d'établissement des alimentations externes et des alimentations générées par les régulateurs 49 et 59.

Dans un mode de réalisation simplifié, un seul régulateur 59 est utilisé. Le signal MSTBY n'est alors pas utile au circuit 50.

Un avantage de l'invention est qu'elle permet l'utilisation d'une mémoire dynamique avec une faible fréquence externe tout en garantissant un fonctionnement correct lorsqu'on a besoin d'accéder à cette mémoire.

Un autre avantage de la présente invention est qu'elle réduit la consommation de la mémoire dynamique pendant son mode de veille et est compatible avec une diminution du niveau de la tension d'alimentation.

Un autre avantage de la présente invention est que l'utilisation du signal d'horloge couramment utilisé pour synchroniser les événements du terminal sur les événements du réseau GSM dans l'application à la téléphonie mobile garantit une synchronisation des éléments et notamment des basculements entre les régulateurs suite aux changements de tension d'alimentation, évitant ainsi tout risque de conflit d'alimentation.

Un autre avantage de la présente invention est qu'elle ne nécessite aucune modification du réseau matriciel de cellules mémoires, des circuits d'entrée-sortie 42, des décodeurs d'adresse 47 et du circuit d'interface de commande 46.

Bien entendu, la présente invention est susceptible de diverses variantes et modifications qui apparaîtront à l'homme de l'art. En particulier, le recours à une mémoire paginée pour effectuer plusieurs accès simultanés lors du rafraîchissement est à la portée de l'homme du métier en utilisant des techniques en elles même connues. De plus, la réalisation pratique de la mémoire dynamique à partir des indications fonctionnelles données ci-dessus est à la portée de l'homme du métier. En outre, bien que l'invention ait été décrite plus particulièrement en relation avec une application à la téléphonie mobile, elle s'applique plus généralement dès que l'on dispose de deux signaux d'horloge externe de fréquences différentes et que l'on souhaite passer d'un mode de fonctionnement normal à un mode de veille.

## Revendications

1. Circuit de téléphonie mobile (1') comprenant au moins un microprocesseur (12) et ses périphériques et modems, **caractérisé en ce qu'**il intègre au moins une première mémoire dynamique (38) comprenant un réseau matriciel de cellules mémoire, et un circuit de commande comportant :
un premier contrôleur de rafraîchissement (48) commandé par un premier signal d'horloge (CKIN) ; et
un deuxième contrôleur de rafraîchissement (58) commandé par un deuxième signal d'horloge (LCK) de fréquence inférieure au premier et correspondant à la fréquence de synchronisation d'événements du réseau GSM.

2. Circuit selon la revendication 1, dans lequel le premier circuit de rafraîchissement (48) est activé en mode de fonctionnement normal tandis que le deuxième circuit de rafraîchissement (58) est activé en mode de veille du circuit intégrant la mémoire dynamique (50).

3. Circuit selon la revendication 2, dans lequel la deuxième fréquence d'horloge (LCK) synchronise les changements de mode de fonctionnement.

4. Circuit selon la revendication 3, comportant au moins deux régulateurs de tension (49, 59) respectivement dédiés aux modes de fonctionnement normal et de veille.

5. Circuit selon l'une quelconque des revendications 1 à 4, intégrant en outre un processeur de traitement du signal (21).

6. Circuit selon la revendication 5, dans lequel le processeur de traitement du signal (21) est associé à une deuxième mémoire dynamique (34).

7. Téléphone mobile comportant un circuit de téléphonie selon l'une quelconque des revendications 1 à 6.

## Claims

1. A mobile telephony circuit (1') comprising at least one microprocessor (12) and its peripherals and modems, **characterized in that** it integrates at least one first DRAM (38) including an array network (41) of memory cells and a control circuit, comprising:
a first refreshment controller (48) controlled by a first clock signal (CKIN); and
a second refreshment controller (58) controlled by a second clock signal (LCK) having a lower frequency than the first one, and corresponding to the synchronization frequency of events of the GSM network.

2. The circuit of claim 1, wherein the first refreshment circuit (48) is activated in normal operation mode while the second refreshment circuit (58) is activated in standby mode of the circuit integrating the DRAM (50).

3. The circuit of claim 2, wherein the second clock frequency (LCK) synchronizes the operation mode switchings.

4. The circuit of claim 3, comprising at least two voltage regulators (49, 59) respectively dedicated to the normal and standby operation modes.

5. The circuit of any of claims 1 to 4, further integrating a signal processor (21).

6. The circuit of claim 5, wherein the signal processor (21) is associated with a second DRAM (34).

7. A mobile phone comprising the telephony circuit of any of claims 1 to 6.

## Patentansprüche

1. Eine Mobil-Telefonie-Schaltung (1'), die wenigstens einen Mikroprozessor (12) und seine Peripherieeinheiten und Modems aufweist, **dadurch gekennzeichnet, dass** sie wenigstens einen ersten DRAM (38), der eine Netzwerkmatrix (41) von Speicherzellen beinhaltet und eine Steuerschaltung integriert, wobei Folgendes vorgesehen ist:
einen ersten Auffrischungs-Controller (48), der durch ein erstes Taktsignal (CKIN) gesteuert wird; und
einen zweiten Auffrischungs-Controller (58) der durch ein zweites Taktsignal (LCK) gesteuert wird, das eine niedrigere Frequenz als das erste besitzt und der Synchronisationsfrequenz von Ereignissen auf dem GSM Netzwerk entspricht.

2. Schaltung nach Anspruch 1, wobei die erste Auffrischungsschaltung (48) in ihrem normalen Betriebsmodus aktiviert wird, während die zweite Auffrischungsschaltung (58) im Bereitschaftsmodus bzw. Stand-By-Modus von der Schaltung, die den DRAM (50) integriert, aktiviert ist.

3. Schaltung nach Anspruch 2, wobei die zweite Taktfrequenz (LCK) die Betriebsmodusumschaltungen synchronisiert.

4. Schaltung nach Anspruch 3, die wenigstens zwei Spannungsregulatoren (49, 59) aufweist, die entsprechend für die Normal- und Bereitschaftsbetriebsmodi bestimmt sind.

5. Schaltung nach irgendeinem der Ansprüche 1 bis 4, die ferner einen Signalprozessor (21) integriert.

6. Schaltung nach Anspruch 5, wobei der Signalprozessor (21) mit einem zweiten DRAM (34) assoziiert ist.

7. Ein Mobiltelefon, das die Telefonie-Schaltung nach irgendeinem der Ansprüche 1 bis 6 aufweist.
